# FASCICULE DE BREVET EUROPEEN

(11) **EP 1 074 369 B1**
(45) Date de publication et mention de la délivrance du brevet: **05.10.2005**
(21) Numéro de dépôt: 00115999.5
(22) Date de dépôt: 26.07.2000
(51) Int. Cl.: B29C 35/10, B29C 70/20

(54) **Procédé de fabrication de pièces en composite fortement sollicitées**
Verfahren zur Herstellung von hochbeanspruchten Verbundteilen
Method for manufacturing highly stressed composite pieces

(30) Priorité: 04.08.1999 FR 9910172
(43) Date de publication de la demande: 07.02.2001
(73) Titulaire: Conception et Développement Michelin S.A., 1762 Givisiez (CH)
(72) Inventeur: Meuwly, Rober, 1780 Cournillens (CH); Hinc, Henri, 1756 Onnens (CH); Mousty, Hervé, 1630 Bulle (CH); Tornare, Marcel, 1700 Fribourg (CH)
(74) Mandataire: Bauvir, Jacques

(56) Documents cités:
- GB-A- 1 522 441
- US-A- 4 666 954
- US-A- 5 609 806

## Description

La présente invention concerne les procédés de fabrication de pièces composites, notamment dans le cas de pièces de formes complexes. Elle se rapporte plus particulièrement aux pièces composites très fortement sollicitées mécaniquement.

Un procédé de fabrication de pièces composites consiste à mouler une pâte par compression sous de hautes pressions puis à effectuer la polymérisation complète avant de démouler. La pâte a été préparée auparavant, et comporte un mélange de résine et de fibres courtes. Ce procédé est très largement utilisé en raison de son aptitude à la fabrication de pièces de formes complexes et de sa grande productivité. Cependant, le procédé de moulage par compression est incompatible avec l'utilisation de fibres de renforcement longues. Pour cette raison, on ne peut pas envisager de réaliser par ce procédé les pièces les plus sollicitées mécaniquement

On connaît d'autres techniques permettant de mettre en oeuvre des fibres de renforcement longues. L'une de ces techniques est appelée "pultrusion". Il s'agit de dérouler les fibres de longueur illimitée, et de les plonger dans un bain de résine pour en assurer l'imprégnation. Ensuite, on les tire au travers d'une filière chauffée, puis au travers d'une enceinte chauffée où s'effectue la polymérisation. On peut de cette façon tirer en continu des produits de section quelconque, dictée par la forme de la filière. Mais il s'agit toujours de produits droits. Une autre technique connue est l'enroulement filamentaire. Sur un mandrin mobile en rotation et en translation, on enroule des ensembles de fibres de renforcement préimprégnées. L'objet fabriqué est polymérisé en étuve. On obtient des tubes, ou des pièces de grandes dimensions comme des réservoirs. Mais outre le fait que la variété de formes est très restreinte, il est difficile de positionner rigoureusement les fibres dans l'épaisseur de la paroi fabriquée. Celles-ci ont tendance à se rapprocher de la surface du mandrin. Il est également difficile de maintenir une proportion de fibres constante dans toute l'épaisseur de la paroi.

On connaît aussi des techniques de moulage de pièces réalisées en composite, faisant notamment appel à une préforme, elle même moulée, pour faciliter la mise en place des fibres de renforcement. Il a été proposé dans le brevet EP 0 655 319 et dans GB-A-1 522 441 de stabiliser une préforme en résine comportant des fibres de renforcement en chauffant la préforme pour obtenir une consistance pâteuse, dont la viscosité permet encore un moulage par compression. Puis on démoule la préforme pâteuse et on la met en place dans un second moule porté à une température plus élevée, afin d'effectuer un moulage par compression de la préforme pâteuse tout en effectuant la polymérisation.

Cependant, le problème d'un tel traitement est qu'il est difficile de maîtriser le stade auquel on amène ce que l'on conviendra d'appeler une « prépolymérisation » (polymérisation initiale partielle). Or il faut atteindre une consistance suffisante pour que les manipulations ultérieures ne provoquent pas trop de désorganisations dans le positionnement des fibres. Bien sûr plus la prépolymérisation est avancée et mieux on maintient les fibres, mais plus il devient difficile de changer la forme lors du moulage ultérieur de la préforme. Par ailleurs, il est en outre très difficile, même quasi impossible, d'interrompre ce processus de polymérisation, qui peut parfois être très rapide en raison de l'exothermie de la réaction. Dans ce cas, la rigidité de la résine renforcée devient rapidement trop importante, ce qui est incompatible avec un moulage ultérieur.

Ainsi, sauf pour des pièces en composite de forme plane ou en barreau ou en tube rectiligne, ou pour d'autres formes simples, on n'a pas réussi jusqu'à ce jour à positionner individuellement des fibres longues exactement selon l'orientation voulue et en densité correctement maîtrisée dans toute l'épaisseur de la pièce. On peut noter que, dans le brevet précité, on coupe les fibres pour faciliter leur mise en oeuvre. Il en résulte une inévitable dégradation de l'effet de renforcement. On entend par "fibres en grande longueur" ou "fibres longues" ou "fibres de longueur infinie" des fibres dont la longueur n'est limitée que par les dimensions de la pièce, ou du moins par les dimensions des parties de la pièce qui doivent être renforcées, sans que cette longueur soit limitée par des contraintes venant du procédé de mise en oeuvre. On entend par "positionner individuellement" le fait de partir de filés ou de tissus plans simples, et non pas de tissus à trois dimensions qui sont chaque fois spécifiques d'une seule pièce fabriquée et qui posent eux aussi d'importants problèmes de manipulation.

L'objectif de l'invention est de proposer un procédé permettant de fabriquer des pièces composites sans dégradation de l'effet de renforcement maximal possible en fonction des fibres sélectionnées, et qui soit applicable à des formes très variées, notamment des rayons de courbure très petits. Pour pouvoir atteindre les formes les plus complexes et aussi dans certains cas pour pouvoir marier la structure composite avec d'autres matériaux comme du caoutchouc, un autre objectif est de pouvoir introduire les constituants de la pièce composite dans un moule ouvert, comme un moule pour pneumatiques, ce qui exclut en pratique les techniques d'injection. L'invention vise à proposer une technique de fabrication qui réponde aux objectifs mentionnés ci-dessus et qui se prête à la mécanisation et aux cadences rapides recherchées pour les fabrications industrielles.

L'invention a pour objet un procédé de fabrication de pièces composites d'épaisseur donnée, comprenant des fibres de renforcement parallèles à au moins une direction de renforcement privilégiée, lesdites fibres étant noyées dans une matrice à base d'une composition comprenant une résine durcissable par un rayonnement ionisant, le procédé comportant les étapes suivantes:
■ disposer lesdites fibres de renforcement sensiblement parallèlement à un plan et les imprégner de ladite composition;
■ exposer la composition contenant lesdites fibres, en couche d'épaisseur inférieure à ladite épaisseur donnée, à un rayonnement ionisant, pour polymériser partiellement la résine, l'exposition à un rayonnement ionisant étant arrêtée après que l'indice D constitué par la dureté Shore D du précomposite divisée par la dureté Shore D du composite final ait atteint une valeur de l'ordre de 0.5 et avant que ledit indice D ait atteint une valeur de l'ordre de 0.7 et obtenir un précomposite dans lequel ladite composition est en phase solide ;
■ prélever des tronçons dans le précomposite et les appliquer sur un support, dont la surface est de forme non plane, en les empilant les uns sur les autres en nombre dicté par ladite épaisseur donnée, et en leur faisant épouser intimement ladite forme du support et ainsi créer un empilage de tronçons contraints ;
■ soumettre l'empilage à un moulage final sous une pression et à une température appropriées afin de poursuivre la polymérisation de la résine et de solidariser les différents tronçons de précomposite.

Le procédé s'adresse plus spécialement à l'utilisation de fibres de longueur infinie. On part d'un filé comportant en général un grand nombre (de l'ordre d'une centaine) de filaments élémentaires d'un diamètre de quelques microns, ces filaments étant tous côte à côte, donc sensiblement parallèles entre eux, à quelques chevauchements près. S'il est en effet impossible de garantir un rangement des filaments absolument parfaitement en parallèle, on veut indiquer par l'expression " sensiblement parallèlement à un plan " qu'il ne s'agit pas d'un cablé ou d'une tresse et que les filaments sont disposés parallèlement, à la précision géométrique de l'arrangement près. La direction de renforcement privilégiée est par exemple la direction des contraintes de traction dans la pièce à fabriquer. Mais on peut aussi partir d'un ruban ou d'un tissu ayant non seulement des fibres orientées parallèlement entre elles, appelées fils de chaîne, que l'on orientera selon ladite direction privilégiée, et contenant en outre d'autres fibres, constituant par exemple des fils de trame, quelle qu'en soit la densité.

L'étape d'imprégnation des fibres n'est pas en soi spécifique de la présente invention, l'homme du métier pouvant aisément sélectionner toute méthode convenable, l'imprégnation pouvant précéder ou suivre la phase d'arrangement des fibres parallèlement à un plan. Le fait d'arranger les fibres parallèlement à un plan a pour but que, au plus tard pendant que l'on commence la polymérisation de la résine, les fibres de renforcement soient ordonnées convenablement pour qu'elles soient, dans la pièce composite finale, judicieusement disposées pour procurer pleinement l'effet de renforcement.

On entend par " précomposite " un matériau dont la résine est prépolymérisée jusqu'à former un milieu solide (stade dit de gélification ou au delà), afin que le précomposite possède une cohésion suffisante pour pouvoir être installé dans un moule ouvert, avec les sollicitations mécaniques que cela suppose, sans risquer un " essorage " des fibres au cours duquel le taux de résine de la préforme diminuerait de façon non maîtrisée. L'objectif de la prépolymérisation est donc d'atteindre un niveau minimal de polymérisation permettant d'éviter tout écoulement de résine lors d'un traitement ultérieur de celle-ci (en fait, un traitement du composite ou de l'article dans lequel il sera incorporé) sous l'action de la température, voire sous l'action de la pression. L'objectif de la prépolymérisation est aussi d'atteindre un niveau minimal de polymérisation permettant de conférer au précomposite une résistance au flambage de ses fibres lors d'une flexion telle qu'imposée par l'étape d'application sur un support de forme non plane.

La polymérisation enclenchée par rayonnement ionisant non seulement permet d'atteindre ce stade, mais permet aussi d'arrêter le processus de polymérisation en cessant d'émettre ledit rayonnement. En effet, l'objectif de la prépolymérisation est encore de ne pas dépasser un niveau maximal de polymérisation, permettant le collage du précomposite soit sur lui-même soit sur du caoutchouc comme cela sera expliqué en détails dans la suite.

La prépolymérisation telle que proposée, associée à une mise en oeuvre du matériau par stratification en couches suffisamment minces, permet de reconstituer un bloc de forme et d'épaisseur quelconques, par rapport à un matériau monolithique préparé avec la même résine et les mêmes fibres en densité identique, préparé par exemple par pultrusion.

Comme rayonnement ionisant convenable, il est proposé d'utiliser un rayonnement dans le spectre allant de 300 nm à 450 nm, ou un faisceau d'électrons accélérés.

Par exemple, on prépare un précomposite en ruban d'épaisseur de 0.1 mm environ (largeur quelconque, choisie plutôt en fonction de la pièce à fabriquer), et la pièce constituée à partir de tronçons de ce ruban jouit des mêmes propriétés qu'un monolithe, c'est à dire une pièce de forme simple qui n'est pas constituée par stratification et superposition de couches minces. En d'autres termes, on n'observe pas de dégradation des propriétés qui sont celles dues à la résine choisie et surtout dues à la fibre de renforcement choisie. Soulignons que, lors de l'empilage, rien n'interdit de croiser les fibres d'un tronçon à l'autre, en fonction de l'effet de renforcement visé pour la pièce en composite à fabriquer. Il s'agit là d'un paramètre de conception de la pièce en composite sur lequel on ne reviendra pas dans la suite, mais qui entre dans le champ de l'invention.

Selon une mise en oeuvre avantageuse de l'invention, lors de l'application des tronçons sur ledit support, on exerce des contraintes sur lesdits tronçons de précomposite afin de les forcer à épouser intimement ladite forme du support. De préférence, la surface du support contre laquelle on empile les tronçons est développable; il est plus facile de leur faire épouser intimement ladite surface. De préférence, on maintient les contraintes de déformation sur lesdits tronçons de précomposite au moins jusqu'au début de l'étape de traitement thermique.

C'est d'une part l'état de prépolymérisation atteint, parfaitement maîtrisé grâce à une prépolymérisation par un rayonnement ionisant, et d'autre part la subdivision en plusieurs couches de faible épaisseur, qui permettent à la fois d'imposer des rayons de courbure assez petits sans qu'il n'en résulte de contraintes résiduelles importantes au sein de chaque tronçon, sans qu'il n'apparaisse de flambage des fibres lors de l'empilage, et sans qu'il n'en résulte de dispersions des fibres dans la section transversale de l'empilage, notamment des dispersions dans l'épaisseur. Le rappel élastique des empilages ainsi réalisés vers une configuration dans laquelle les contraintes internes seraient nulles est relativement faible, ce qui permet assez aisément de maintenir mécaniquement ou de figer la déformation imposée sans gêner les étapes ultérieures de réalisation de la pièce composite finale.

Le fait d'effectuer le commencement de la polymérisation de la résine en couche d'épaisseur très inférieure à l'épaisseur de la pièce composite finale facilite les déformations dont on a parlé ci-dessus. En considérant le rayon de courbure minimal " r " de ladite pièce composite, le commencement de la polymérisation est avantageusement effectué en couche d'épaisseur " e " telle que « e » est plus petit que « r » divisé par 20. De préférence, et notamment pour faciliter le maintien provisoire de l'état déformé avant que la suite du procédé ne fige définitivement la structure du produit final, le commencement de la polymérisation est effectué en couche d'épaisseur " e " telle que « e » est plus petit que « r » divisé par 150.

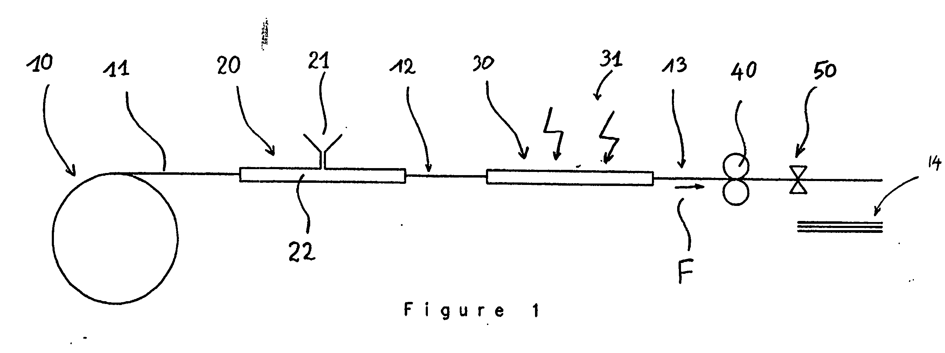

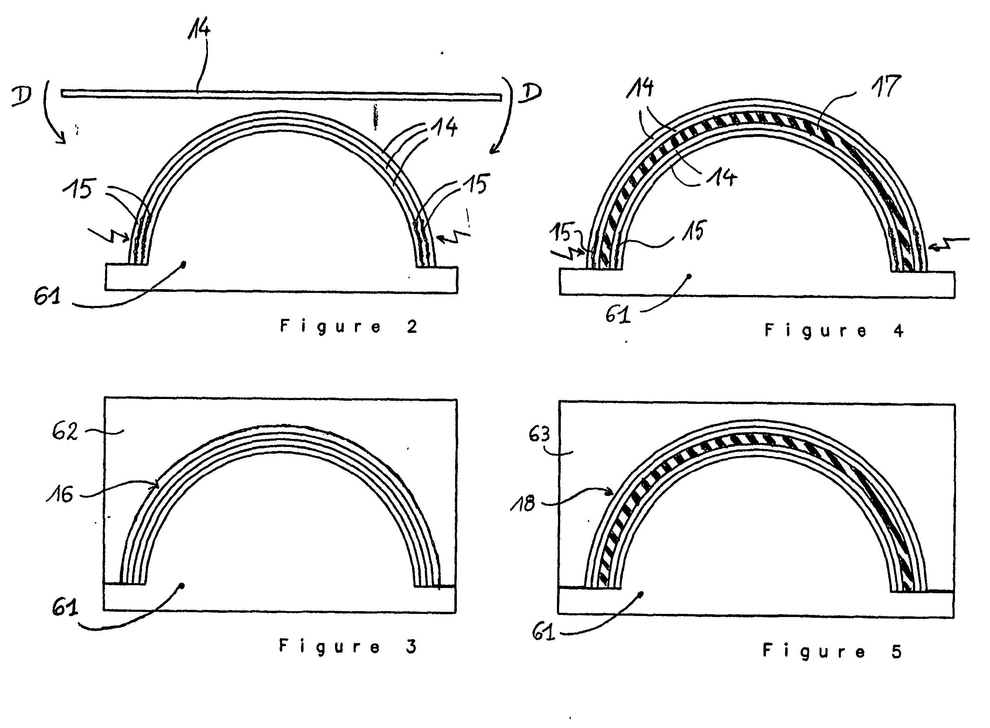

Deux exemples de mise en oeuvre du procédé selon l'invention vont maintenant être décrits à l'aide des figures annexées suivantes :
■ la figure 1 est un schéma partiel d'une installation mettant oeuvre une première phase du procédé selon l'invention ;
■ la figure 2 est un schéma illustrant une phase ultérieure du procédé selon l'invention appliqué à la réalisation d'une pièce composite ;
■ la figure 3 est un schéma illustrant la phase suivant celle illustrée à la figure 2;
■ la figure 4 est un schéma illustrant une phase ultérieure du procédé selon l'invention appliqué à la réalisation d'une pièce lamifiée comportant à la fois une pièce composite et du caoutchouc ;
■ la figure 5 est un schéma illustrant la phase suivant celle illustrée à la figure 4.

On voit à la figure 1 une bobine 10 contenant un filé 11 qui, dans l'exemple illustré, est constitué par des fibres de verre. On a schématisé ensuite un dispositif d'imprégnation 20 comportant un réservoir 21 contenant une composition à base d'une résine durcissable et un photoinitiateur approprié pour le rayonnement par lequel ladite composition va être traitée. Le dispositif d'imprégnation 20 comporte une chambre d'imprégnation 22. Il en ressort un préimprégné 12 qui est introduit dans un dispositif de prépolymérisation 30, dans lequel le préimprégné 12 est prépolymérisé par un rayonnement ionisant, le traitement étant effectué à l'abri de l'oxygène. Quant au rayonnement 31 auquel on expose la composition, sa longueur d'onde est typiquement inférieure à 450 nanomètres, de préférence comprise entre 300 nm et 450 nm. On peut par exemple utiliser une lampe à ultraviolets. Des galets 40 entraînent le précomposite 13 obtenu dans le sens de la flèche F. Enfin, une cisaille 50 permet de prélever des tronçons 14 dans le précomposite fabriqué en continu, pour les mettre en oeuvre comme expliqué dans la suite.

Ensuite vient la phase de mise en oeuvre des tronçons 14 de précomposite. A la figure 2, on voit un support 61 dont la forme permet de fabriquer un objet en " C " (par exemple un ressort en C). Les tronçons 14 de précomposite sont déformés (voir flèches D à la figure 2) pour leur faire épouser la forme du support 61. Les tronçons sont disposés sur le support 61 de façon à ce que les fibres soient parallèles au plan de la figure 2, en cheminant d'un bout à l'autre de l'objet en C.

Le niveau de prépolymérisation doit être suffisamment élevé pour permettre l'empilage des tronçons 14 sur le support voulu sans provoquer de flambage des fibres 11 situées à l'intérieur de la courbure du tronçon 14 déformé, et pour éviter que la composition à base de résine ne se répande en dehors du précomposite lors de la déformation, et aussi lors d'un traitement thermique ultérieur sous pression. Ce niveau de prépolymérisation doit cependant être suffisamment faible pour que la poursuite de la polymérisation d'un empilage de plusieurs tronçons de ce précomposite sous l'effet conjugué de la température et de la pression crée des liaisons au travers de l'interface entre deux tronçons de précomposite adjacents, afin d'obtenir un objet en matériau composite doté d'excellentes propriétés mécaniques, notamment en flexion et en cisaillement.

Il est proposé de contrôler expérimentalement le niveau de prépolymérisation au moyen d'une analyse de la dureté Shore D du précomposite. Les valeurs de dureté Shore données ci-dessous sont mesurées avec un duromètre Shore D tel que décrit dans la norme NF T 46-052. L'exposition à un rayonnement ionisant est de préférence arrêté par exemple après que la dureté Shore D du précomposite soit devenue supérieure à 45 et avant que la dureté Shore D du précomposite soit supérieure à 65 si l'on vise des dureté Shore D de l'ordre de 90 à 95 pour le composite final. Plus généralement, on propose que l'étape d'exposition à un rayonnement ionisant soit arrêté après que l'indice D constitué par la dureté Shore D du précomposite divisée par la dureté Shore D du composite final ait atteint une valeur de l'ordre de 0.5 et avant que ledit indice D ait atteint une valeur de l'ordre de 0.7.

On peut aussi contrôler expérimentalement le niveau de prépolymérisation au moyen d'une analyse de la température de transition vitreuse T_{g} de la composition du précomposite. On propose une règle de bonne pratique selon laquelle, en considérant l'indice T = T_{gf} - T_{gpr}, T_{gpr} étant la température de transition vitreuse de la composition du précomposite et T_{gf} étant la température de transition vitreuse de la composition du composite final, l'exposition à un rayonnement ionisant est arrêtée après que l'indice T soit devenu inférieur à 120°C et avant que ledit indice T soit devenu inférieur à 30°C. Par exemple, dans le cas où la température de transition vitreuse T_{g} de la composition du composite final serait de l'ordre de 160°C, l'exposition à un rayonnement ionisant est arrêtée après que la température de transition vitreuse T_{g} de la composition du précomposite ait atteint une valeur de l'ordre de 40°C et avant que la température de transition vitreuse T_{g} de la composition du précomposite ait atteint une valeur de l'ordre de 130°C.

Au passage, on peut faire remarquer que le niveau de prépolymérisation du précomposite est tel que l'on se trouve au-delà du point de gélification de la résine. Le niveau de prépolymérisation voulu est atteint en adaptant par exemple le temps de traitement aux rayonnements ionisants (vitesse de défilement imposée par les galets 40, longueur du dispositif de prépolymérisation 30).

Pour faire épouser au précomposite la forme de la surface du support 61, on peut envisager les possibilités suivantes. Soit lesdits tronçons 14 de précomposite sont empilés et déformés individuellement (voir flèches D à la figure 2) pour leur faire épouser chacun successivement la forme du support 61. Soit lesdits tronçons 14 de précomposite sont empilés et déformés par groupes de plusieurs, ou tous ensemble, pour leur faire épouser collectivement la forme du support 61.

Dans tous les cas, bien que le nerf des tronçons 14 soit assez faible, il convient de faire en sorte que l'empilage de tronçons de précomposite garde une forme en C, au moins suffisamment pour permettre la mise en oeuvre des étapes suivantes. On peut rendre provisoirement solidaires les uns des autres les différents tronçons 14 de l'empilage en interposant au moins partiellement une couche 15 de ladite composition, par exemple aux extrémités du C et à la surface de l'un au moins des tronçons à maintenir l'un sur l'autre, comme montré à la figure 2. Il suffit d'exposer au moins partiellement ladite couche 15 à un rayonnement ionisant, par exemple un rayonnement ultraviolet - visible, même au travers des tronçons 14 comme schématisé à la figure 2, pour polymériser partiellement la résine de ladite couche 15. Bien entendu, tant que la liaison entre tronçons adjacents décrite ci-dessus n'est pas réalisée, ou plus généralement tant que, quelle que soit la manière, on n'a pas fait en sorte que les tronçons se maintiennent spontanément à la déformation imposée, il faut les maintenir en appliquant extérieurement les forces appropriées.

En variante de la solidarisation provisoire des différents tronçons 14 par photoinitiation, on peut envisager de soumettre l'empilage à un moulage sous une pression et à une température appropriées (par exemple de l'ordre de 130°C) afin de poursuivre au moins partiellement la polymérisation de la résine, avant d'autres étapes intermédiaires éventuelles et avant le moulage final. Dans une autre variante, on peut envisager de rendre provisoirement solidaires les uns des autres les différents tronçons 14 de l'empilage en interposant une couche de maintien provisoire comportant essentiellement une composition de haute viscosité. Signalons encore que ces différentes méthodes peuvent aussi être utilisées concomitamment.

La figure 3 schématise l'étape finale. Un contre-moule 62 est amené par dessus le support 61 revêtu d'un empilage 16 de tronçons 14 de précomposite. On effectue un moulage final sous pression, par exemple de l'ordre de 10 bars. La température lors du moulage sous pression est de préférence supérieure à la température de transition vitreuse T_{g} de la composition du précomposite. A titre indicatif, une température de traitement convenable est de l'ordre de 150°C au moins. Les propriétés finales du matériau ne sont pas uniquement et même pas principalement dues à ladite prépolymérisation. Elles résultent aussi en grande partie du traitement thermique pendant cette étape de moulage final, qui assure un excellent collage des tronçons préalablement empilés les uns sur les autres.

Grâce au fait que le contrôle du degré de prépolymérisation n'est pas effectué par voie thermique, il est possible d'ajuster la viscosité de la composition pendant l'étape d'imprégnation des fibres par une élévation modérée de la température de ladite composition. Par exemple, on peut chauffer jusqu'à 80°C environ, sans qu'il n'en résulte d'effet sensible sur la stabilité de la résine. Cela permet une bien meilleure imprégnation des fibres. On peut ainsi disposer d'un paramètre de réglage de la phase d'imprégnation indépendant des paramètres des étapes ultérieures du procédé.

Quant aux résines convenables, à titre d'illustration, mentionnons que la résine peut être choisie dans le groupe constitué par les résines vinylesters et les résines polyesters insaturées, ou encore peut être une résine époxyde. Et en ce qui concerne les fibres de renforcement, mentionnons qu'elles peuvent être choisies parmi les fibres organiques comme les fibres polyacrylique haute ténacité ou les fibres polyacrylonitrile oxydé, les fibres d'alcool polyvinylique haute ténacité, les fibres polyamide aromatique ou les fibres polyamide-imide ou les fibres polyimide, les chlorofibres, les fibres polyester haute ténacité ou les fibres polyester aromatique, les fibres polyéthylène haute ténacité, les fibres polypropylène haute ténacité, les fibres de cellulose ou de rayonne ou de viscose haute ténacité, les fibres polyphénylène benzobisoxazole, les fibres polyéthylène naphténate, ou elles peuvent être choisies parmi les fibres inorganiques comme les fibres de verre, les fibres de carbone, les fibres de silice, les fibres céramiques (alumine, aluminosilicate, borosilicoaluminate). De préférence, le procédé utilise des fibres unidirectionnelles parallèles à ladite au moins une direction de renforcement privilégiée, disposées sensiblement parallèlement pendant l'imprégnation par ladite composition.

Le tableau suivant donne des résultats comparatifs sur différents échantillons 1 à 5, préparés au moyen de différentes résines. Les échantillons préparés sont des blocs parallélépipèdiques d'épaisseur de 2 mm.

Dans tous les exemples (témoins et échantillons), les fibres de renforcement sont des fibres de verre, du type indiqué. Sous la colonne " préparation ", " moulage direct " signifie que l'on a préparé un monolithe équivalent sans stratification aucune ; des fibres parallèles entre elles sont régulièrement réparties dans la matrice en résine. Tous les échantillons ont subi un moulage final avec traitement thermique sous pression. Le témoin 1 a été préparé avec un préimprégné de fibres unidirectionnelles, disponible dans le commerce sous la dénomination Prepreg Vicotex (référence BE M10 / 29.5% / 25x2400 - Bande de verre P122 EPOXY 60 mm), et constitué de fibres de verre unidirectionnelles noyées dans une résine epoxy, fabriqué par Hexcel Composites S.A.. Le témoin 2 comporte des filés disponibles dans le commerce sous la dénomination PPG 2001 300Tex, noyés dans une résine disponible dans le commerce sous la dénomination Atlac 590. Le témoin 3 est obtenu par empilage de 10 tronçons de précomposite, le précomposite ayant été prépolymérisé par voie thermique. Il comporte les mêmes fibres de verre noyées dans la même résine que le témoin 2.

Dans tous les exemples de mise en oeuvre de l'invention, la composition comprend un photo initiateur de polymérisation et le rayonnement est compris dans le spectre ultraviolet - visible. Dans ce cas, de préférence, on utilise une fibre de verre.

Tous les échantillons de l'invention sont obtenus par empilage de 10 tronçons de précomposite de 0.2mm d'épaisseur, protégées par deux films nylon de 50 microns. Le précomposite a été prépolymérisé par exposition pendant le nombre de secondes indiqué sous rayonnement ultraviolet-visible (Tube UV Philips TLK 40W/03) placé à une distance de 180 mm du tronçon. Le précomposite s'avère suffisamment transparent aux rayonnements pour que la prépolymérisation soit bien homogène et pour que le maintien provisoire tel qu'exposé ci-dessus, dans lequel le traitement aux rayonnements est effectué au travers d'un tronçon déjà prépolymérisé, soit efficace.

| | Résine | Fibre de verre | Taux de fibre | Préparation | Durcissement |
|---|---|---|---|---|---|
| Témoin 1 | Epoxy M10 | Vetrotex RO 99 2400 P122 | 72 | Moulage direct | 1 h à 120°C + 1h à 150°C |
| Témoin 2 | Atlac 590 | PPG 2001 300Tex | 73 | Moulage direct | 15 min à 120°C + 15 min à 165°C |
| Témoin 3 | Atlac 590 | PPG 2001 300Tex | 74 | Empilage 10 couches | 15 min à 120°C + 15 min à 165°C |
| Echantillon 1 | Atlac 590 | PPG 2001 300Tex | 70 | Traitement UV pendant 30 secondes puis empilage de 10 couches | 15 min à 165°C |
| Echantillon 2 | Heltron 970 | PPG 2001 300Tex | 68 | Traitement UV pendant 30 secondes puis empilage de 10 couches | 15 min à 165°C |
| Echantillon 3 | RD903 + styrène | PPG 2001 300Tex | 72 | Traitement UV pendant 20 secondes puis empilage de 10 couches | 15 min à 165°C |
| Echantillon 4 | RD904 + styrène | PPG 2001 300Tex | 69 | Traitement UV pendant 20 secondes puis empilage de 10 couches | 15 min à 165°C |
| Echantillon 5 | Derakane 470-36S | PPG 2001 300Tex | 72 | Traitement UV pendant 20 secondes puis empilage de 10 couches | 15 min à 165°C |

Les résines des témoins 2 et 3 et de tous les échantillons sont toutes des résines Vinylesters. (Epoxy Vinyl Ester Resins). Le fournisseur de la résine ATLAC 590 est DSM - BASF Structural Resins. Notons au passage que, en variante de ce qui a été dit au paragraphe précédent, on peut ajuster la viscosité de ladite composition en lui ajoutant un monomère copolymérisable avec la résine et en en faisant varier la proportion. Par exemple le monomère dont on fait varier la proportion est le styrène. Le photoinitiateur est l'oxyde de bis(2, 4, 6-triméthylbenzoyl)-phénylphosphine (photoinitiateur Irgacure 819). Le fournisseur de la résine « Heltron 970 » est Ashland Chemical. Le fournisseur des résines « RD903 » et « RD904 » est UCB Chemicals. Le fournisseur de la résine « Derakane 470-36S » est Dow.

La résine ATLAC 590 est une résine époxydique insaturée par un acide monocarboxylique insaturé (voir formule ci-dessous). Cette résine comprend :
- une résine à base de bisphenol A, le bisphenol A apparaissant entre les crochets : 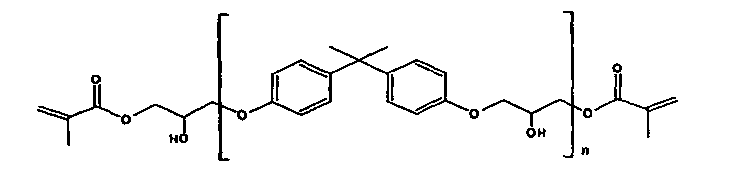
- une résine novolaque apparaissant entre les crochets : 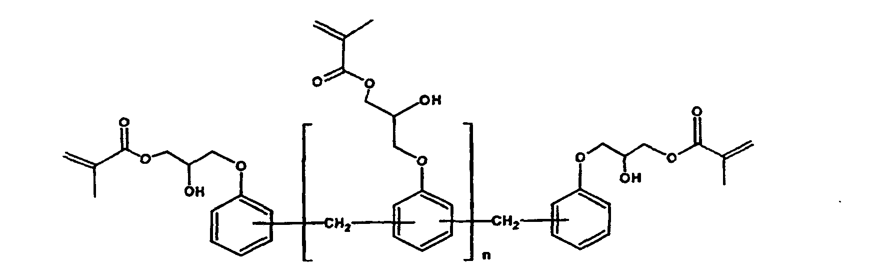
- un monomère dont la proportion influence la viscosité, le styrène:

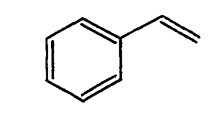

Le tableau suivant illustre les propriétés mécaniques.

| | Test de Flexion | | Test de cicaillement |
|---|---|---|---|
| | Module d'Young | Contrainte rupture | Contraire rupture |
| | (MPa) | (MPa) | (MPa) |
| Témoin 1 | 40977 | 1374 | 78 |
| Témoin 2 | 37142 | 1145 | 83 |
| Témoin 3 | 28140 | 733 | 28 |

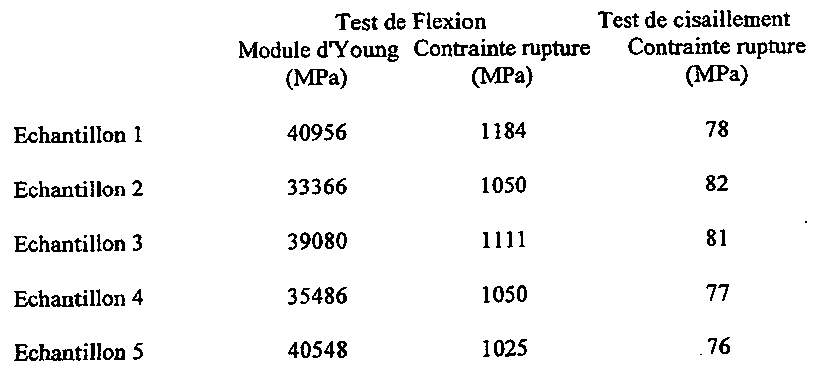

Les témoins 1 et 2 illustrent les meilleures performances que l'on peut attendre d'un monolithe correctement préparé. Les performances mécaniques des échantillons sont illustrées par la valeur du Module de Young, par la contrainte maximale à la rupture de l'échantillon en test de flexion (Norme Afnor T57-302), et par la contrainte de cisaillement maximale à la rupture (Norme Afnor T57-303), cette dernière propriété permettant notamment de bien mettre en évidence la qualité de la solidarisation entre les strates du témoin 3 et de l'échantillon selon l'invention. On observe une dégradation notable des propriétés du témoin 3, surtout une dégradation considérable de la contrainte de cisaillement maximale à la rupture. En revanche, l'invention permet de retrouver sensiblement les propriétés du témoin 2, qui est un monolithe directement comparable. Les propriétés mécaniques du matériau sont les mêmes, que les tronçons de précomposite aient été déformés ou non.

Le tableau suivant illustre le traitement de polymérisation partielle. Il donne une description qualitative du précomposite obtenu pour différentes valeurs du temps de traitement au rayonnement ultra violet. Les échantillons concernés contiennent des fibres de verre PPG 300 Tex à 70% en poids, noyées dans une résine Atlac 590 avec 2% de Photoinitiateur Irgacure 819. Le précomposite est préparé en couche d'épaisseur 0.25mm et de 30 mm de largeur, les fibres de verre étant unidirectionnelles. La couche est protégée en surface par un film nylon de 50 microns d'épaisseur pour l'irradiation. L'irradiation est assurée par 2 tubes UV Philips TLK 40W/03 placés à une distance de 180 mm de la couche à traiter. On forme ensuite un empilage de 15 tronçons de 30 mm de précomposite. On évalue la résistance au flambage par enroulement manuel d'un échantillon orienté dans le sens des fibres sur un cylindre de 30 mm de rayon. On évalue la résistance à une pression de 30 bars, sous une température de 110°C. La dureté Shore D est mesurée selon la norme déjà indiquée.

| Temps d'exposition au rayonnement UV (sec) | Aspect de surface | Dureté Shore D | Résistance au flambage | Résistance à la pression |
|---|---|---|---|---|
| 10 | poissant | 20 | nombreux flambages | composite écrasé, résine exsudée |
| 20 | non poissant | 35 | flambages | composite écrasé |
| 25 | non poissant | 45 | peu de flambage | composite pas écrasé |
| 27 | non poissant | 50 | pas de flambage | composite pas écrasé |
| 30 | non poissant | 65 | pas de flambage | composite pas écrasé |
| 40 | non poissant | 75 | pas de flambage | composite pas écrasé |
| 60 | non poissant | 80 | pas de flambage | composite pas écrasé |

On voit que l'on obtient des résultats satisfaisants à partir d'un temps de traitement supérieur à 25 secondes. L'étape d'irradiation est de préférence limitée dans le temps dès que la dureté Shore D convenable a été atteinte, le lecteur étant renvoyé aux explications déjà fournies.

L'invention permet d'obtenir un produit intermédiaire constitué essentiellement par un précomposite préparé en grande longueur et en épaisseur inférieure à 0.3 millimètre, comportant des fibres de renforcement parallèles à au moins une direction de renforcement privilégiée, lesdites fibres étant noyées dans une matrice à base d'une composition comprenant une résine durcissable par un rayonnement ionisant, dans lequel la température de transition vitreuse T_{g} de la matrice est comprise entre 40°C et 130°C, et dans lequel la dureté Shore D de ce précomposite est comprise entre 50 et 65, revêtu d'un film de protection opaque au rayonnement ultraviolet - visible. Grâce au film de protection, ce produit intermédiaire peut être stocké sans que le taux de prépolymérisation n'évolue sensiblement. Il peut être utilisé sur un autre site et mis en oeuvre selon les indications du procédé de l'invention.

Selon un autre aspect particulier, l'invention concerne un procédé de solidarisation d'un matériau composite à du caoutchouc. Le procédé décrit permet de réaliser un lamifié dans lequel lesdites pièces composites sont intimement solidarisées à du caoutchouc. A cette fin et de préférence, sur la surface de chaque tronçon destinée à recevoir une couche de caoutchouc, on dépose une couche de colle résorcinol formaldéhyde latex (RFL), ladite couche de colle RFL étant séchée sans atteindre une température supérieure à 100°C, c'est à dire sans traitement thermique à haute température, avant de recevoir ladite couche de caoutchouc. Lors du moulage final, on obtient une bonne solidarisation des tronçons de précomposite entre eux et entre les éléments en composite et le caoutchouc.

L' invention s'étend donc aussi à un matériau dans lequel, entre certaines desdites strates au moins, est interposée une couche 17 de composition à base d'élastomère vulcanisable au soufre. De manière avantageuse, entre certaines desdites strates au moins et ladite couche de composition à base d'élastomère vulcanisable au soufre, est interposée une couche de colle résorcinol formaldéhyde latex (RFL).

La figure 4 montre le support 61 d'abord recouvert par deux tronçons 14 de précomposite empilés, déformés et maintenus provisoirement par une couche 15 de la composition prépolymérisée par rayonnement ultraviolet. Les deux strates ainsi déposées et préstabilisées conservent spontanément leur forme en C. Une couche 17 d'une composition à base de caoutchouc crue est ensuite déposée par dessus le deuxième tronçon 14. Bien entendu, la composition à base de caoutchouc peut épouser sans grande difficulté la forme imposée aux premières couches de précomposite. Puis l'on peut poursuivre l'empilage de tronçons 14 de précomposite, avec maintien provisoire de l'état déformé. On peut bien entendu utiliser tous les moyens décrits pour la figure 2.

L'étape de moulage final, illustrée à la figure 5, permet à la fois le bon collage des tronçons 14 entre eux, la vulcanisation du caoutchouc, la polymérisation complète de la résine et la solidarisation du caoutchouc et de la résine. Un contre-moule 63 est amené par dessus le support 61 revêtu d'un empilage 18 de tronçons 14 de précomposite avec interposition d'une couche 17 de caoutchouc. On effectue un moulage final avec traitement thermique sous pression.

L'utilisation d'une colle RFL non polymérisée, déposée sur ces tronçons de précomposite, permet de ne pas recourir à des élastomères spéciaux pour coller le caoutchouc sur le matériau composite.

## Revendications

1. Procédé de fabrication de pièces composites d'épaisseur donnée, comprenant des fibres de renforcement (11) parallèles à au moins une direction de renforcement privilégiée, lesdites fibres étant noyées dans une matrice à base d'une composition comprenant une résine durcissable par un rayonnement ionisant, le procédé comportant les étapes suivantes :
■ disposer lesdites fibres de renforcement sensiblement parallèlement à un plan et les imprégner de ladite composition ;
■ exposer la composition contenant lesdites fibres, en couche d'épaisseur inférieure à ladite épaisseur donnée, à un rayonnement ionisant (31), pour polymériser partiellement la résine l'exposition à un rayonnement ionisant étant arrêtée après que l'indice D constitué par la dureté Shore D du précomposite divisée par la dureté Shore D du composite final ait atteint une valeur de l'ordre de et avant que ledit indice D ait atteint une valeur de l'ordre de 0.7 et obtenir un précomposite dans lequel ladite composition est en phase solide ;
■ prélever des tronçons (14) dans le précomposite et les appliquer sur un support (61), dont la surface est de forme non plane, en les empilant les uns sur les autres en nombre dicté par ladite épaisseur donnée, et en leur faisant épouser intimement ladite forme du support et ainsi créer un empilage de tronçons contraints ;
■ soumettre l'empilage à un moulage final sous une pression et à une température appropriées afin de poursuivre la polymérisation de la résine et de solidariser les différents tronçons de précomposite.

2. Procédé selon la revendication 1, dans lequel la surface du support est développable.

3. Procédé selon l'une des revendications 1 ou 2 dans lequel, en considérant un rayon de courbure minimal " r " de ladite pièce composite, le commencement de la polymérisation est effectué en couche d'épaisseur " e " telle que « e » est plus petit que r/20.

4. Procédé selon l'une des revendications 1 à 3 dans lequel, en considérant le rayon de courbure minimal " r " de ladite pièce composite, le commencement de la polymérisation est effectué en couche d'épaisseur " e " telle que « e » est plus petit que r/150.

5. Procédé selon l'une des revendications 1 à 4, dans lequel lesdits tronçons (14) de précomposite sont empilés et déformés individuellement pour leur faire épouser chacun successivement ladite forme du support.

6. Procédé selon l'une des revendications 1 à 5, dans lequel lesdits tronçons (14) de précomposite sont empilés et déformés par groupes de plusieurs pour leur faire épouser collectivement ladite forme du support.

7. Procédé selon l'une des revendications 1 à 6, dans lequel la température lors du moulage sous pression à l'étape de moulage final est supérieure à la température de transition vitreuse T_{g} de la composition du précomposite.

8. Procédé selon l'une des revendications 1 à 7 dans lequel l'exposition à un rayonnement ionisant est arrêtée après que l'indice T = T_{gf} - T_{gpr}, T_{gpr} étant la température de transition vitreuse de la composition du précomposite et T_{gf} étant la température de transition vitreuse de la composition du composite final soit devenu inférieur à 120°C et avant que ledit indice T soit devenu inférieur à 30°C.

9. Procédé selon l'une des revendications 1 à 8 dans lequel l'étape pendant laquelle on expose ladite composition à un rayonnement ionisant est effectuée à l'abri de l'oxygène.

10. Procédé selon l'une des revendications 1 à 9 dans lequel, lors de l'application des tronçons (14) sur ledit support (61), on exerce des contraintes extérieurement sur lesdits tronçons de précomposite afin de les forcer à épouser intimement ladite forme du support et on maintient les dites contraintes exercées extérieurement au moins jusqu'au début de l'étape de traitement thermique.

11. Procédé selon l'une des revendications 1 à 9 dans lequel on rend provisoirement solidaires les uns des autres les différents tronçons de l'empilage en interposant au moins partiellement une couche (15) de ladite composition, et en exposant au moins partiellement ladite couche interposée à un rayonnement ionisant, pour prépolymériser la résine de ladite couche interposée.

12. Procédé selon l'une des revendications 1 à 9 dans lequel on rend provisoirement solidaires les uns des autres les différents tronçons de l'empilage en soumettant l'empilage à un pré-moulage sous une pression et à une température appropriées afin de poursuivre au moins partiellement la polymérisation de la résine, avant d'autres étapes intermédiaires éventuelles et avant le moulage final.

13. Procédé selon l'une des revendications 1 à 9 dans lequel on rend provisoirement solidaires les uns des autres les différents tronçons de l'empilage en interposant une couche de maintien provisoire comportant essentiellement une composition de haute viscosité.

14. Procédé selon l'une des revendications 1 à 13, dans lequel on ajuste la viscosité de ladite composition, pendant l'étape d'imprégnation des fibres, par une élévation de température de ladite composition.

15. Procédé selon l'une des revendications 1 à 14, dans lequel la résine est choisie dans le groupe constitué par les résines vinylesters et les résines polyesters insaturées.

16. Procédé selon l'une des revendications 1 à 14, dans lequel la résine est une résine époxyde.

17. Procédé selon la revendication 15, dans lequel ladite composition comprend un monomère copolymérisable avec la résine et on ajuste la viscosité de ladite composition en faisant varier la proportion de monomère.

18. Procédé selon la revendication 17, dans lequel ledit monomère est du styrène.

19. Procédé selon l'une des revendications 1 à 18, dans lequel ladite composition comprend un photo initiateur de polymérisation et le rayonnement (31) est compris dans le spectre ultraviolet - visible.

20. Procédé selon la revendication 15, dans lequel ladite composition comprend un photo initiateur de polymérisation qui est l'oxyde de bis(2, 4, 6-triméthylbenzoyl)-phénylphosphine et le rayonnement (31) est compris dans le spectre ultraviolet - visible.

21. Procédé selon l'une des revendications 1 à 18, dans lequel les fibres de renforcement (11) sont choisies dans le groupe constitué par les fibres polyacrylique haute ténacité, les fibres polyacrylonitrile oxydé, les fibres d'alcool polyvinylique haute ténacité, les fibres polyamide aromatique, les fibres polyamide-imide, les fibres polyimide, les chlorofibres, les fibres polyester haute ténacité, les fibres polyester aromatique, les fibres polyéthylène haute ténacité, les fibres polypropylène haute ténacité, les fibres de cellulose, les fibres de rayonne, les fibres de viscose haute ténacité, les fibres polyphénylène benzobisoxazole, les fibres polyéthylène naphténate, les fibres de verre, les fibres de carbone, les fibres de silice, les fibres céramiques.

22. Procédé selon l'une des revendications 19 ou 20, dans lequel on utilise une fibre de verre.

23. Procédé selon l'une des revendications 1 à 22, dans lequel on interpose une couche (17) de composition à base d'élastomère vulcanisable au soufre entre certains des tronçons de précomposite.

24. Procédé selon la revendication 23 dans lequel, à la surface de chaque tronçon destinée à recevoir une couche de composition à base d'élastomère vulcanisable au soufre, on dépose une couche de colle résorcinol formaldéhyde latex (RFL), ladite couche de colle RFL étant séchée sans atteindre une température supérieure à 100°C avant de recevoir ladite couche de composition à base d'élastomère vulcanisable au soufre.

25. Procédé selon l'une des revendications 23 ou 24, dans lequel l'étape de moulage final permet à la fois la solidarisation des couches de l'empilage, la vulcanisation de la composition à base d'élastomère vulcanisable au soufre, la polymérisation complète de la résine et la solidarisation de la composition à base d'élastomère vulcanisable au soufre et de la résine.

26. Procédé selon l'une des revendications 1 à 25, utilisant des fibres unidirectionnelles parallèles à ladite au moins une direction de renforcement privilégiée, disposées sensiblement parallèlement pendant l'imprégnation par ladite composition.

27. Procédé selon l'une des revendications 1 à 26, dans lequel l'étape consistant à exposer la composition obtenir un précomposite et menée jusqu'à ce que l'on atteigne un niveau minimal de polymérisation permettant de conférer au précomposite une résistance au flambage de ses fibres lors d'une flexion telle qu'imposée par l'étape d'application sur un support de forme non plane et arrêtée de façon à ne pas dépasser un niveau maximal de polymérisation permettant le collage du précomposite sur lui-même.

28. Précomposite préparé en grande longueur et en épaisseur inférieure à 0.3 millimètre, comportant des fibres de renforcement parallèles à au moins une direction de renforcement privilégiée, lesdites fibres étant noyées dans une matrice à base d'une composition comprenant une résine durcissable par un rayonnement ionisant, dans lequel la température de transition vitreuse T_{g} de la matrice est comprise entre 40°C et 130°C, et dans lequel la dureté Shore D de ce précomposite est comprise entre 50 et 65, revêtu d'un film de protection opaque au rayonnement ultraviolet - visible.

29. Précomposite selon la revendication 28, dans lequel la résine est choisie dans le groupe constitué par les résines vinylesters et les résines polyesters insaturées.

30. Précomposite selon la revendication 28, dans lequel la résine est une résine époxyde.

31. Précomposite selon la revendication 29, dans lequel ladite composition comprend un monomère copolymérisable avec la résine.

32. Précomposite selon la revendication 31, dans lequel ledit monomère est du styrène.

33. Précomposite selon l'une des revendications 28 à 32, dans lequel ladite composition comprend un photo initiateur de polymérisation et le rayonnement (31) est compris dans le spectre ultraviolet - visible, et dans lequel le revêtement est opaque au rayonnement ultraviolet - visible.

34. Précomposite selon la revendication 29, dans lequel ladite composition comprend un photo initiateur de polymérisation qui est l'oxyde de bis(2, 4, 6-triméthylbenzoyl)-phénylphosphine et le rayonnement (31) est compris dans le spectre ultraviolet - visible.

35. Précomposite selon l'une des revendications 28 à 34, dans lequel les fibres de renforcement (11) sont choisies dans le groupe constitué par les fibres de verre et les fibres de carbone.

36. Précomposite selon l'une des revendications 28 à 35, dans lequel les fibres de renforcement (11) sont des fibres unidirectionnelles.

## Patentansprüche

1. Verfahren zur Herstellung von Verbundteilen mit vorgegebener Dicke, die Verstärkungsfasern (11) parallel zu mindestens einer bevorzugten Verstärkungsrichtung enthalten, wobei die Fasern in eine Matrix auf der Basis einer Zusammensetzung eingebettet sind, die ein durch eine ionisierende Strahlung härtbares Harz enthält, wobei das Verfahren die folgenden Schritte umfasst:
• Anordnen der Verstärkungsfasern im wesentlichen parallel zu einer Ebene und Imprägnieren der Verstärkungsfasern mit der Zusammensetzung;
• Bestrahlen der Zusammensetzung, die die Fasern enthält, in einer Schicht mit einer Dicke, die kleiner als die vorgegebene Dicke ist, mit einer ionisierenden Strahlung (31), um das Harz teilweise zu polymerisieren, wobei die Bestrahlung mit der Strahlung beendet wird, nachdem der Kennwert D, der aus der Shore-Härte D des Vorverbundmaterials dividiert durch die Shore-Härte D des fertigen Verbundmaterials besteht, einen Wert von etwa 0,5 erreicht hat und bevor der Kennwert D einen Wert von etwa 0,7 erreicht hat, wodurch ein Vorverbundmaterial erhalten wird, in dem die Zusammensetzung in fester Phase vorliegt;
• Entnehmen von Stücken (14) aus dem Vorverbundmaterial und Aufbringen dieser Stücke auf einen Träger (61), dessen Oberfläche eine nicht ebene Form aufweist, indem sie in einer Anzahl aufeinander gestapelt werden, die durch die vorgegebene Dicke festgelegt ist, und indem man die Stücke innig an die Form des Trägers anschmiegt, um so eine Stapelung von unter einer Spannung stehenden Stücken zu erzeugen;
• abschließende formgebende Behandlung der Stapelung unter einem geeigneten Druck und bei einer geeigneten Temperatur, um die Polymerisation des Harzes fortzusetzen und die verschiedenen Stücke aus dem Vorverbundmaterial fest miteinander zu verbinden.

2. Verfahren nach Anspruch 1, wobei die Oberfläche des Trägers ausziehbar ist.

3. Verfahren nach einem der Ansprüche 1 oder 2, bei dem unter Berücksichtigung eines minimalen Krümmungsradius "r" des Verbundteils der Beginn der Polymerisation in einer Schicht mit einer Dicke "e" durchgeführt wird, die so ist, dass "e" kleiner als r/20 ist.

4. Verfahren nach einem der Ansprüche 1 bis 3, bei dem unter Berücksichtigung eines minimalen Krümmungsradius "r" des Verbundteils der Beginn der Polymerisation in einer Schicht mit einer Dicke "e" durchgeführt wird, die so ist, dass "e" kleiner als r/ 150 ist

5. Verfahren nach einem der Ansprüche 1 bis 4, wobei die Stücke (14) aus dem Vorverbundmaterial individuell gestapelt und verformt werden, um sie nacheinander an die Form des Trägers anzuschmiegen.

6. Verfahren nach einem der Ansprüche 1 bis 5, wobei die Stücke (14) aus dem Vorverbundmaterial in Gruppen aus mehreren Stücken gestapelt und verformt werden, um sie gemeinsam an die Form des Trägers anzuschmiegen.

7. Verfahren nach einem der Ansprüche 1 bis 6, wobei die Temperatur bei der Formgebung unter Druck im abschließenden Formgebungsschritt oberhalb der Glasübergangstemperatur T_{g} der Zusammensetzung des Vorverbundmaterials liegt.

8. Verfahren nach einem der Ansprüche 1 bis 7, wobei das Bestrahlen mit einer ionisierenden Strahlen beendet wird, nachdem der Kennwert T = T_{gf} - T_{gpr}, wobei T_{gpr} die Glasübergangstemperatur der Zusammensetzung des Vorverbundmaterials ist und T_{gf} die Glasübergangstemperatur der Zusammensetzung des fertigen Verbundmaterials ist, unter 120 °C gesunken ist und bevor der Kennwert T unter 30 °C gesunken ist.

9. Verfahren nach einem der Ansprüche 1 bis 8, wobei der Schritt, in dem die Zusammensetzung einer ionisierenden Strahlung ausgesetzt wird, unter Ausschluss von Sauerstoff durchgeführt wird.

10. Verfahren nach einem der Ansprüche 1 bis 9, wobei beim Aufbringen der Stücke (14) auf den Träger (61) von außen Kräfte auf die Stücke aus dem Vorverbundmaterial ausgeübt werden, um die Stücke dazu zu bringen, sich innig an die Form des Trägers anzuschmiegen, und wobei die von außen einwirkenden Kräfte mindestens bis zum Beginn des Wärmebehandlungsschrittes aufrecht erhalten werden.

11. Verfahren nach einem der Ansprüche 1 bis 9, wobei die verschiedenen Stücke der Stapelung provisorisch fest miteinander verbunden werden, indem eine Schicht (15) aus dieser Zusammensetzung mindestens teilweise eingefügt wird und indem die eingefügte Schicht mindestens teilweise einer ionisierenden Strahlung ausgesetzt wird, um das Harz dieser eingefügten Schicht in ein Präpolymer zu überführen.

12. Verfahren nach einem der Ansprüche 1 bis 9, wobei die verschiedenen Stücke der Stapelung provisorisch miteinander verbunden werden, indem die Stapelung einer Vorverformung unter einem geeigneten Druck und bei einer geeigneten Temperatur unterzogen wird, um die Polymerisation des Harzes mindestens teilweise durchzuführen, vor anderen gegebenenfalls durchzuführenden Zwischenschritten und vor der abschließenden Formgebung.

13. Verfahren nach einem der Ansprüche 1 bis 9, wobei die verschiedenen Stücke der Stapelung provisorisch miteinander verbunden werden, indem eine provisorische Halteschicht eingefügt wird, die im wesentlichen eine Zusammensetzung von hoher Viskosität enthält.

14. Verfahren nach einem der Ansprüche 1 bis 13, wobei die Viskosität der Zusammensetzung während des Schrittes, in dem die Fasern imprägniert werden, durch eine Erhöhung der Temperatur der Zusammensetzung eingestellt wird.

15. Verfahren nach einem der Ansprüche 1 bis 14, wobei das Harz aus der Gruppe ausgewählt wird, die aus den Vinylesterharzen und den ungesättigten Polyesterharzen besteht.

16. Verfahren nach einem der Ansprüche 1 bis 14, wobei das Harz ein Epoxidharz ist.

17. Verfahren nach Anspruch 15, wobei die Zusammensetzung ein mit dem Harz copolymerisierbares Monomer enthält und die Viskosität der Zusammensetzung eingestellt wird, indem der Anteil des Monomers variiert wird.

18. Verfahren nach Anspruch 17, wobei es sich bei dem Monomer um Styrol handelt.

19. Verfahren nach einem der Ansprüche 1 bis 18, wobei die Zusammensetzung einen Photoinitiator zum Initiieren der Polymerisation enthält und die Strahlung (31) aus dem Spektralbereich stammt, der die Ultraviolettstrahlung und das sichtbare Licht umfasst.

20. Verfahren nach Anspruch 15, wobei die Zusammensetzung einen Photoinitiator zum Initiieren der Polymerisation enthält, bei dem es sich um Bis(2,4,6-trimethylbenzoyl)-phenylphosphinoxid handelt und die Strahlung (31) in dem Spektrum liegt, das ultraviolettes Licht und sichtbares Licht umfasst.

21. Verfahren nach einem der Ansprüche 1 bis 18, wobei die Verstärkungsfasern (11) aus der Gruppe ausgewählt werden, die aus den hochfesten Polyacrylfasern, den Fasern aus oxidiertem Polyacrylnitril, den hochfesten Polyvinylalkoholfasern, den Fasern aus aromatischem Polyamid, den Polyamidimidfasern, den Polyimidfasern, den Chlorfasern, den hochfesten Polyesterfasern, den Fasern aus aromatischem Polyester, den hochfesten Polyethylenfasern, den hochfesten Polypropylenfasern, den Cellulosenfasern, den Reyonfasern, den hochfesten Viskosefasern, den Polyphenylenbenzobisoxazolfasern, den Polyethylennaphthenatfasern, den Glasfasern, den Carbonfasern, den Kieselsäurefasern, den Keramikfasern besteht.

22. Verfahren nach einem der Ansprüche 19 oder 20, bei dem eine Glasfaser verwendet wird.

23. Verfahren nach einem der Ansprüche 1 bis 22, wobei eine Schicht (17) aus einer Zusammensetzung auf der Basis eines mit Schwefel vulkanisierbaren Elastomers zwischen einigen Stücken aus dem Vorverbundmaterial eingefügt wird.

24. Verfahren nach Anspruch 23, wobei auf die Oberfläche jedes Stücks, das dafür vorgesehen ist, eine Schicht aus einer Zusammensetzung auf der Basis eines mit Schwefel vulkanisierbaren Elastomers aufzunehmen, eine Schicht aus einem Resorcin-Formaldehyd-Latex-Klebstoff (RFL) aufgebracht wird, wobei die Schicht aus dem RFL-Klebstoff getrocknet wird, ohne dass eine Temperatur oberhalb von 100 °C erreicht wird, bevor die Schicht aus der Zusammensetzung auf der Basis eines mit Schwefel vulkanisierbaren Elastomers aufgebracht wird.

25. Verfahren nach einem der Ansprüche 23 oder 24, wobei der Schritt der abschließenden Formgebung gleichzeitig die feste Verbindung der Schichten der Stapelung, die Vulkanisation der Zusammensetzung auf der Basis des mit Schwefel vulkanisierbaren Elastomers, die vollständige Polymerisation des Harzes und die feste Verbindung der Zusammensetzung auf der Basis des mit Schwefel vulkanisierbaren Elastomers mit dem Harz ermöglicht.

26. Verfahren nach einem der Ansprüche 1 bis 25, für das unidirektionale Fasern parallel zu der mindestens einen bevorzugten Verstärkungsrichtung verwendet werden, die während der Imprägnierung mit dieser Zusammensetzung im wesentlichen parallel angeordnet werden.

27. Verfahren nach einem der Ansprüche 1 bis 26, wobei der Schritt, der darin besteht, die Zusammensetzung der Strahlung auszusetzen, um ein Vorverbundmaterial zu erhalten, durchgeführt wird, bis ein minimales Ausmaß der Polymerisation erreicht wird, das es ermöglicht, dem Vorverbundmaterial eine Beständigkeit gegen das Knicken seiner Fasern bei einer Verbiegung zu geben, wie sie durch den Schritt hervorgerufen wird, in dem das Vorverbundmaterial auf einen Träger mit nicht ebener Form aufgebracht wird, und wobei dieser Schritt so beendet wird, dass ein maximales Ausmaß der Polymerisation nicht überschritten wird, wodurch das Verkleben des Vorverbundmaterials mit sich selbst ermöglicht wird.

28. Vorverbundmaterial, das in großer Länge und in einer Dicke von weniger als 0,3 Millimeter hergestellt wird, das Verstärkungsfasern parallel zu mindestens einer bevorzugten Verstärkungsrichtung enthält, wobei die Fasern in eine Matrix auf der Basis einer Zusammensetzung eingebettet sind, die ein durch eine ionisierende Strahlung härtbares Harz enthält, wobei die Glasübergangstemperatur T_{g} der Matrix im Bereich von 40 bis 130 °C liegt und wobei die Shore-Härte D dieses Vorverbundmaterials im Bereich von 50 bis 65 liegt, das mit einer Schutzfolie überzogen ist, die für Ultraviolettstrahlung und sichtbares Licht undurchlässig ist.

29. Vorverbundmaterial nach Anspruch 28, wobei das Harz aus der Gruppe ausgewählt ist, die aus den Vinylesternharzen und den ungesättigten Polyesterharzen besteht.

30. Vorverbundmaterial nach Anspruch 28, wobei das Harz ein Epoxidharz ist.

31. Vorverbundmaterial nach Anspruch 29, wobei die Zusammensetzung ein mit dem Harz copolymerisierbares Monomer enthält.

32. Vorverbundmaterial nach Anspruch 31, wobei es sich bei dem Monomer um Styrol handelt.

33. Vorverbundmaterial nach einem der Ansprüche 28 bis 32, wobei die Zusammensetzung einen Photoinitiator zum Initiieren der Polymerisation enthält und die Strahlung (31) in dem Spektralbereich liegt, der die Ultraviolettstrahlung und das sichtbare Licht umfasst, und wobei der Überzug für Ultraviolettstrahlung und sichtbares Licht undurchlässig ist.

34. Vorverbundmaterial nach Anspruch 29, wobei die Zusammensetzung einen Photoinitiator zum Initiieren der Polymerisation enthält, bei dem es sich um Bis(2,4,6-trimethylbenzoyl)-phenylphosphinoxid handelt, und die Strahlung (31) in dem Spektralbereich liegt, der die Ultraviolettstrahlung und das sichtbare Licht umfasst.

35. Vorverbundmaterial nach einem der Ansprüche 28 bis 34, wobei die Verstärkungsfasern (11) aus der Gruppe ausgewählt sind, die aus den Glasfasern und den Carbonfasern besteht.

36. Vorverbundmaterial nach einem der Ansprüche 28 bis 35, wobei die Verstärkungsfasern (11) unidirektionale Fasern sind.

## Claims

1. A process for manufacturing composite parts of given thickness, comprising reinforcement fibres (11) which are parallel to at least one preferred direction of reinforcement, said fibres being embedded in a matrix based on a composition comprising a resin which can be hardened by ionising radiation, the process comprising the following stages:
■ arranging said reinforcement fibres substantially parallel to one plane and impregnating them with said composition;
■ exposing the composition containing said fibres, in a layer of thickness less than said given thickness, to ionising radiation (31), in order partially to polymerise the resin, the exposure to ionising radiation being stopped once the index D constituted by the Shore D hardness of the precomposite divided by the Shore D hardness of the final composite has reached a value of the order of 0.5 and before the index D has reached a value of the order of 0.7, and to obtain a precomposite in which said composition is in the solid phase;
■ taking lengths (14) from the precomposite and applying them to a support (61), the surface of which is non-planar in shape, by stacking them on one another in a number dictated by said given thickness, and by causing them to fit snugly against said shape of the support, and thus to create a stack of stressed lengths;
■ subjecting the stack to final moulding at a suitable pressure and temperature to continue the polymerisation of the resin and to join the different lengths of precomposite.

2. A process according to Claim 1, in which the surface of the support is developable.

3. A process according to one of Claims 1 or 2, in which, considering a minimum radius of curvature "r" of said composite part, the start of prepolymerisation is effected in a layer of thickness "e" is such that "e" is smaller than r/20.

4. A process according to one of Claims 1 to 3, in which, considering the minimum radius of curvature "r" of said composite part, the start of polymerisation is effected in a layer of thickness "e" is such that "e" is smaller than r/150.

5. A process according to one of Claims 1 to 4, in which said lengths (14) of precomposite are stacked and deformed individually to make them each fit snugly in succession against said shape of the support.

6. A process according to one of Claims 1 to 5, in which said lengths (14) of precomposite are stacked and deformed in groups of several lengths to make them fit snugly collectively against said shape of the support.

7. A process according to one of Claims 1 to 6, in which the temperature during the moulding under pressure in the final moulding stage is higher than the glass transition temperature T_{g} of the composition of the precomposite.

8. A process according to one of Claims 1 to 7, in which the exposure to ionising radiation is stopped once the index T = T_{gf} - T_{gpr}, T_{gpr} being the glass transition temperature of the composition of the precomposite and T_{gf} being the glass transition temperature of the composition of the final composite, has become less than 120°C and before said index T has become less than 30°C.

9. A process according to one of Claims 1 to 8, in which the stage during which said composition is exposed to ionising radiation is carried out with oxygen excluded.

10. A process according to one of Claims 1 to 9, in which, during the application of the lengths (14) to said support (61), stresses are exerted externally on said lengths of precomposite in order to force them to fit snugly against said shape of the support, and said stresses are kept exerted externally at least until the start of the heat treatment stage.

11. A process according to one of Claims 1 to 9, in which the different lengths of the stack are made temporarily integral with each other by inserting at least in part a layer (15) of said composition, and by exposing said inserted layer, at least in part, to ionising radiation, in order to prepolymerise the resin of said inserted layer.

12. A process according to one of Claims 1 to 9, in which the different lengths of the stack are made temporarily integral with each other by subjecting the stack to premoulding at a suitable pressure and temperature in order to continue the polymerisation of the resin, at least in part, before any other intermediate stages and before the final moulding.

13. A process according to one of Claims 1 to 9, in which the different lengths of the stack are made temporarily integral with each other by inserting a temporary holding layer comprising essentially a high-viscosity composition.

14. A process according to one of Claims 1 to 13, in which the viscosity of said composition is adjusted, during the stage of impregnation of the fibres, by increasing the temperature of said composition.

15. A process according to one of Claims 1 to 14, in which the resin is selected from the group consisting of unsaturated vinylester resins and polyester resins.

16. A process according to one of Claims 1 to 14, in which the resin is an epoxy resin.

17. A process according to Claim 15, in which said composition comprises a monomer which can be copolymerised with the resin and the viscosity of said composition is adjusted by varying the proportion of monomer.

18. A process according to Claim 17, in which said monomer is styrene.

19. A process according to one of Claims 1 to 18, in which said composition comprises a polymerisation photoinitiator and the radiation (31) lies within the visible ultraviolet spectrum.

20. A process according to Claim 15, in which said composition comprises a polymerisation photoinitiator which is bis(2,4,6-trimethylbenzoyl)-phenylphosphine oxide and the radiation (31) lies within the visible ultraviolet spectrum.

21. A process according to one of Claims 1 to 18, in which the reinforcement fibres (11) are selected from the group comprising high-tenacity polyacrylic fibres, oxidised polyacrylonitrile fibres, high-tenacity polyvinyl alcohol fibres, aromatic polyamide fibres, polyamide-imide fibres, polyimide fibres, chlorofibres, high-tenacity polyester fibres, aromatic polyester fibres, high-tenacity polyethylene fibres, high-tenacity polypropylene fibres, cellulose fibres, rayon fibres, high-tenacity viscose fibres, polyphenylene benzobisoxazole fibres, polyethylene naphthenate fibres, glass fibres, carbon fibres, silica fibres or ceramic fibres.

22. A process according to one of Claims 19 or 20, in which a glass fibre is used.

23. A process according to one of Claims 1 to 22, in which a layer (17) of composition based on sulphur-vulcanisable elastomer is interposed between some of the lengths of precomposite.

24. A process according to Claim 23 in which, on the surface of each length intended to receive a layer of composition based on sulphur-vulcanisable elastomer, there is deposited a layer of resorcinol formaldehyde latex glue (RFL), said layer of RFL glue being dried without reaching a temperature of greater than 100°C before receiving said layer of composition based on sulphur-vulcanisable elastomer.

25. A process according to one of Claims 23 or 24, in which the final moulding stage makes it possible to do all of: join the layers of the stack, to vulcanise the composition based on sulphur-vulcanisable elastomer, to polymerise the resin completely and to join the composition based on sulphur-vulcanisable elastomer and the resin.

26. A process according to one of Claims 1 to 25, using unidirectional fibres parallel to the said at least one preferred direction of reinforcement, arranged substantially parallel during impregnation by said composition.

27. A process according to one of Claims 1 to 26, in which the step consisting of exposing the composition obtaining a precomposite and [sic] carried out until a minimum level of polymerisation is obtained which makes it possible to impart to the precomposite a resistance to buckling of its fibres upon bending such as imposed by the stage of application on a support of non-planar shape and stopped so as not to exceed a maximum level of polymerisation permitting the gluing of the precomposite on to itself.

28. A precomposite prepared in a great length and in a width of less than 0.3 millimetres, comprising reinforcement fibres which are parallel to at least one preferred direction of reinforcement, said fibres being embedded in a matrix based on a composition comprising a resin which can be hardened by ionising radiation, in which the glass transition temperature T_{g} of the matrix is between 40°C and 130°C, and in which the Shore D hardness of this precomposite is between 50 and 65, coated with a protective film opaque to visible ultraviolet radiation.

29. A precomposite according to Claim 28, in which the resin is selected from the group consisting of unsaturated vinylester resins and polyester resins.

30. A precomposite according to Claim 28, in which the resin is an epoxy resin.

31. A precomposite according to Claim 29, in which said composition comprises a monomer which can be copolymerised with the resin.

32. A precomposite according to Claim 31, in which said monomer is styrene.

33. A precomposite according to one of Claims 28 to 32, in which said composition comprises a polymerisation photoinitiator and the radiation (31) lies within the visible ultraviolet spectrum, and in which the coating is opaque to visible ultraviolet radiation.

34. A precomposite according to Claim 29, in which said composition comprises a polymerisation photoinitiator which is bis(2,4,6-trimethylbenzoyl)-phenylphosphine oxide and the radiation (31) lies within the visible ultraviolet spectrum.

35. A precomposite according to one of Claims 28 to 34, in which the reinforcement fibres (11) are selected from the group consisting of glass fibres and carbon fibres.

36. A precomposite according to one of Claims 28 to 35, in which the reinforcement fibres (11) are unidirectional fibres.
